# EUROPEAN PATENT SPECIFICATION

(11) **EP 0 165 692 B1**
(45) Date of publication and mention of the grant of the patent: **31.03.1993**
(21) Application number: 85303158.1
(22) Date of filing: 03.05.1985
(51) Int. Cl.: G06F 12/02

(54) **Magnetic bubble memory component**
Magnetischer Blasenspeicher-Bestandteil
Composant de mémoire à bulles magnétiques

(30) Priority: 07.05.1984 JP 91457/84
(43) Date of publication of application: 27.12.1985
(73) Proprietor: FUJITSU LIMITED, Kawasaki-shi, Kanagawa 211 (JP)
(72) Inventor: Maegawa, Harumi c/o Fujitsu Limited, Kawasaki-shi Kanagawa 211 (JP); Takai, Sakan c/o Fujitsu Limited, Kawasaki-shi Kanagawa 211 (JP); Sukeda, Toshiaki c/o Fujitsu Limited, Kawasaki-shi Kanagawa 211 (JP); Irie, Shoji c/o Fujitsu Limited, Kawasaki-shi Kanagawa 211 (JP); Kobata, Shoichi c/o Fujitsu Limited, Kawasaki-shi Kanagawa 211 (JP)
(74) Representative: Sunderland, James Harry

(56) References cited:
- EP-A- 0 071 423
- FR-A- 2 109 444
- US-A- 4 180 863
- PATENT ABSTRACTS OF JAPAN, vol. 7, no. 73 (P-186)[1218], 25th March 1983; & JP-A-58 3181 (NIPPON DENKI K.K.) 08-01-1983

## Description

The present invention relates to a magnetic bubble memory component.

Semiconductor memory devices such as integrated circuit (IC) memory devices are playing a major role in the provision of large capacity storage for electronic apparatus such as computers. However, because of the volatility of data stored in such memories, auxiliary storage is indispensable so that data can be sheltered and maintained when power is not supplied, for example before operation is resumed after a power down.

A magnetic bubble memory device is a non-volatile memory device capable of retaining stored data information without power supply. In addition, a magnetic bubble memory device has many advantages such as ease of re-writing, high reliability due to the absence of moving elements, compact size, a structure suitable for mounting onto a printed circuit board, etc. As such, the field of application of magnetic bubble memory devices has been increasingly expanding. Particularly, magnetic bubble memory devices are applicable to file memories and program loaders for various apparatuses such as numerical control (NC) devices, robots, production control terminals, point-of-sale (POS) terminals, office automation (OA) apparatus, and the like.

The constitution and operation of magnetic bubble memory devices is well-known, but an example will be described briefly hereinafter.

A magnetic bubble memory device comprises a substrate consisting of a magnetic garnet single crystal film epitaxially grown on a non-magnetic garnet substrate (a gadolinium-gallium-garnet, GGG, substrate), and a transfer circuit, generator circuit and detector circuit as well as means for retaining and transferring magnetic bubbles are formed on the single crystal film.

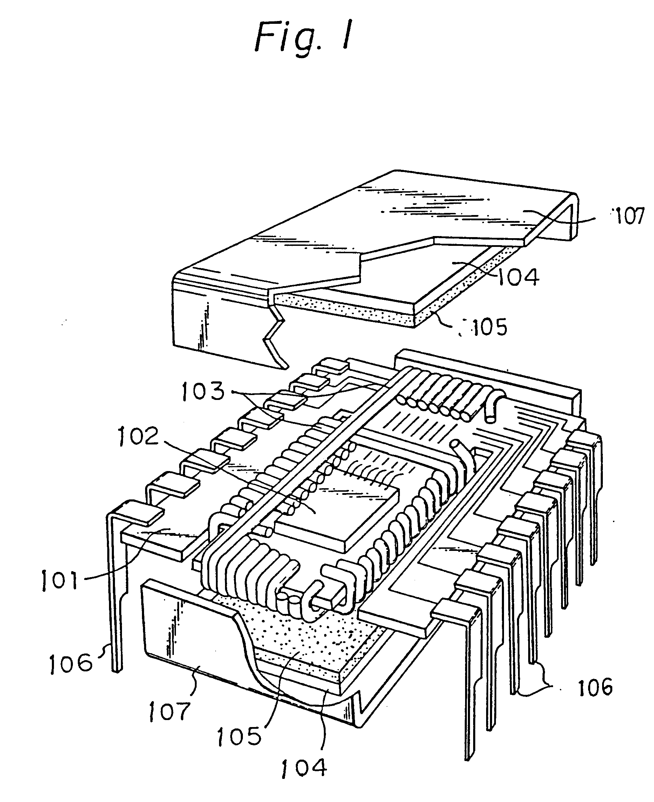

Generally, a magnetic bubble memory device has a structure as shown in Fig. 1 of the accompanying drawings, which gives a partly exploded perspective view. The device comprises a memory chip 102 mounted on an insulator substrate 101, a X-Y coil arrangement 103, permanent magnetic plates referred as bias magnets 104, ferrite yokes 105, lead terminals 106, and a shield case 107. The X-Y coil arrangement 103 generates a rotating magnetic field which is applied to the memory chip 102 to transfer magnetic bubbles stored in the chip 102. The bias magnets 104 and the ferrite yokes 105 apply a bias magnetic field to the memory chip 102 in order to retain magnetic bubbles therein. The lead terminals 106 are used to connect the magnetic bubble chip 102 to associated peripheral circuits for controlling bubble movement inside the chip and for external delivery of output signals. The total device is accommodated in a shield case 107.

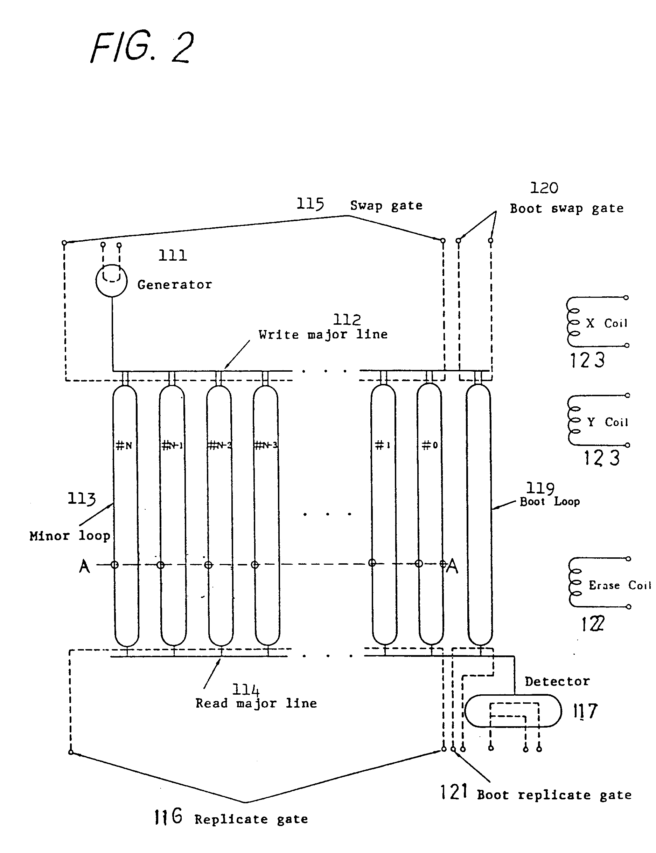

Fig. 2 of the accompanying drawings is a schematic plan view of a pattern configuration formed on a magnetic bubble memory chip 102. On a magnetic garnet crystal film grown epitaxially on a non-magnetic garnet substrate (not shown), various elements are formed: a bubble generator 111 coupled with a write-in major line 112, a read-out major line 114, and a large number of minor-loops 113 for storing information with which both major lines, 112 and 114, are coupled. The major lines 112 and 114, and the minor loops 113, are composed of a series of conductor patterns, half disk-shaped patterns, for example. The conductor patterns are formed of iron-nickel alloy (Permalloy) having a high magnetic permeability by a conventional film forming method, and magnetic bubbles are transferred therethrough and stored therein. A group of signals stored in the patterns located along a "horizontal" line (as shown in Fig. 2 by broken line A-A) is referred to as a page.

When write-in is effected signals are applied to the bubble generator 111, bubble signals are generated therein and, under the control of a swap-gate 115, bubble signals are transferred in a sequence composing a page, which is transferred through the major line 112 to minor loops 113 by driving X-Y coils 123.

When read-out of signals is effected, stored information signals in the form of magnetic bubbles are copied by a replicate gate 116 and transferred to a detector 117 which is made of Permalloy. Thereby, the information signals are converted to current signals utilizing a magnetoresistance effect of Permalloy, and detecting difference of resistance of relevant Permalloy patterns. The current signals are amplified and converted to a TTL (transistor-transistor logic) level by a sense amplifier (not shown).

A boot loop 119, a boot swap gate 120 and a boot replicate gate 121 provide information with regard to inherent defects of the minor loops 113 to provide for skipping of these defects during write-in and read-out operations.

In Fig. 2, a X-Y coil arrangement is schematically illustrated at 123, and an erase coil is schematically illustrated at 122.

The gates mentioned above are driven by respective analog drivers: analog circuits which require analog technology for their design. These analog circuits comprise function drivers, a coil driver and a sense amplifier. These circuits are referred to as analog peripheral circuits. On the other hand, a magnetic bubble memory apparatus also has a group of digital circuits, referred as digital peripheral circuits, which handle digital signals to control the analog circuits according to write-in signals or read-out signals provided by external controlling circuitry.

As indicated above, a magnetic bubble memory apparatus comprises magnetic bubble memory devices, analog peripheral circuits and digital peripheral circuits, which are usually mounted on a printed circuit board. As a result, magnetic bubble memory apparatus has been built into a user's overall apparatus, as its storage unit, utilizing electrical connecting means such as connectors and mechanical fixing means such as fixing frames.

US-A-4 180 863 discloses a printed circuit board on which a plurality of groups of magnetic bubble devices are mounted together with, for example, pluralities of sense drivers, integrated circuit drivers and other support circuitry componentry. The board has edge connector pads for plugging into edge connector slide contact receptacles. It is indicated that, as an alternative to the edge connector pads, terminal pins might be provided which extend perpendicularly from a surface of the board opposite to its main component mounting surface.

According to the present invention, there is provided a magnetic bubble memory component, incorporating a magnetic bubble memory device and analog peripheral circuitry for driving and controlling the device,
wherein
the device and electrical elements forming the analog peripheral circuitry are mounted on a substrate of the component,
the device is mounted on the substrate by means of lead terminals of the device, and
the component incorporates protection elements for protecting the device lead terminals from contact by external bodies, thereby to avoid electrostatic discharge damage such as might be caused by contact with a charged body,
and wherein
the substrate carries also lead terminals of the component, for receiving electrical input signals for the peripheral circuitry and for delivering electrical output signals therefrom, which extend perpendicularly with respect to a main surface of the substrate and are arranged along two lines, on opposite side edges of the substrate, whereby the component is mountable on a printed circuit board by means of its lead terminals by dip soldering, in the fashion of a dip-packaged IC.

An embodiment of the present invention provides a magnetic bubble memory component in the form of a module mountable to a storage device as a non-volatile memory unit.

An embodiment of the present invention provides a construction of a module including a magnetic bubble memory device and its analog peripheral circuits, easily mountable onto a printed circuit board of a storage apparatus.

A module embodying the present invention can be easily mounted on a printed circuit board without the use of connectors and fixing frames as mentioned above. This provides a user with a magnetic bubble memory device component which can be handled for mounting on a printed circuit board like other electronic elements, to afford freedom of design and easiness of mounting.

An embodiment of the present invention provides a magnetic bubble memory module having outer lead terminals by which the module is mountable on an ordinary printed circuit board in a similar way to that in which IC's are mounted.

Further, an embodiment of the present invention provide means protecting a magnetic bubble memory device accommodated in such a module from electrostatic discharge damage, for example as might be caused by the touch of a charged body such as an operator.

An embodiment of the present invention provides a magnetic bubble memory module comprising associated analog peripheral circuits, so that users can handle the module without design skill relating to analog circuits.

A magnetic bubble memory module embodying the present invention comprises a magnetic bubble memory device and analog peripheral circuits, not including digital peripheral circuits. The outer size of the module is minimized to facilitate realization of high packing density in apparatus into which the module is built.

Output and input terminals, outer lead terminals, for connecting the module to its digital peripheral circuits are of conventional type, like those of a packaged IC, being arranged in lines so that the module can be mounted onto a printed circuit board by dip-soldering, in the same or similar soldering operation as is used for mounting other electrical elements such as ICs, resistors and the like. This provides the designer of apparatus using the module with a great deal of design freedom and flexibility of design. In addition, design knowledge of analog circuitry is not required of the designer, who will usually be familiar with the design of digital circuits but not analog circuits.

In addition, for operators in a production line, a magnetic bubble memory module embodying the present invention can provide an advantage of easy handling, obtained by using a protecting insulator cover or a protector for the lead terminals of the magnetic bubble memory device to prevent electrostatic discharge damage such as might otherwise be caused by touching of those terminals by fingers of operators or other charged bodies. Generally, the data stored in a magnetic bubble memory device can be easily damaged by electrostatic discharge. Particularly, if boot loop information stored in boot loops, indicating defects of minor loops, is disturbed, the whole module becomes unavailable. The lead terminals of the magnetic bubble memory device are carefully covered or protected by a plastic cover or projections so that the terminals are protected from any electrostatic discharge damage.

Furthermore, in an embodiment of the present invention a substrate of the magnetic bubble memory module may be reinforced by a plastic frame surrounding the edge of the substrate adhered thereto with the aid of plastic adhesion material. In addition, heatsinks may be arranged on the surface of the module supported by the plastic frame to dissipate heat generated for example in a coil driver and function drivers which are mounted on a front surface of the substrate (a printed circuit board) of the module.

The above-mentioned features of embodiments of the present invention are not always employed instantaneously in combination with one another, but can be selectively applied depending on the design of the relevant magnetic bubble memory module.

Reference is made, by way of example, to the accompanying drawings, in which:-
Fig. 1 is a partly exploded perspective view illustrating the structure of a magnetic bubble memory device;
Fig. 2 is a schematic plan view of the magnetic bubble memory device of Fig. 1, illustrating a pattern configuration formed on a garnet substrate of the device;
Fig. 3 is a schematic block circuit diagram of a magnetic bubble memory module embodying the present invention, illustrating circuit block configuration and input/output signals received by or output from relevant circuit blocks;
Fig. 4 is a schematic block circuit diagram of a configuration of a magnetic bubble memory apparatus employing magnetic bubble memory modules embodying the present invention;
Fig. 5 is an exploded, perspective view of a magnetic bubble memory module, for assistance in explaining the present invention, illustrating relevant parts for assistance in explaining the mounting arrangement of the module;
Fig. 6 is a perspective view, partially cut away, of a magnetic bubble memory module embodying the present invention;
Fig. 7 is an exploded, perspective view of the magnetic bubble memory module of Fig. 6, illustrating individual parts which are assembled to form the module;
Fig. 8(a) is a front view (view from above) of the magnetic bubble memory module of Fig. 6;
Fig. 8(b) is a side view of the magnetic bubble memory module of Fig. 6;
Fig. 8(c) is a rear view (view from below) of the magnetic bubble memory module of Fig. 6;
Fig. 9 is a perspective view of another embodiment of the present invention; and
Fig. 10 is a magnified perspective view, partially cut away, of a protector used in the magnetic bubble memory module of Fig. 9, illustrating the protector mounted on a printed circuit board of a magnetic bubble memory device of the module so as to protect lead terminals of the magnetic bubble memory device.

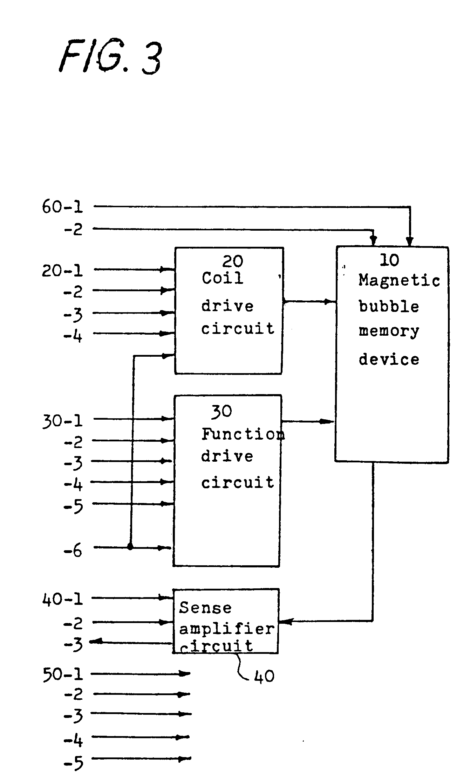

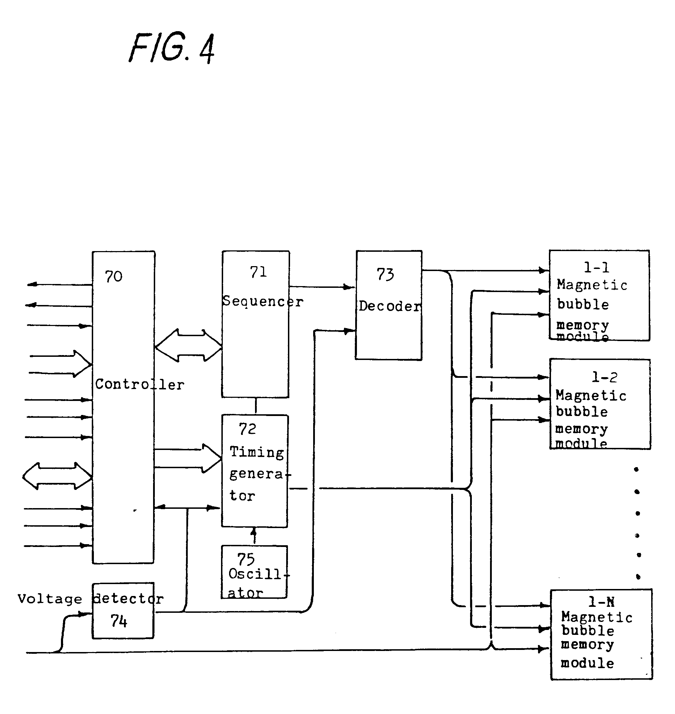

Fig. 3 is a block circuit diagram schematically illustrating a magnetic bubble memory module in accordance with an embodiment of the present invention. The module comprises a magnetic bubble memory device 10, a coil drive circuit 20, a function drive circuit 30 and a sense amplifier circuit 40. X and Y coil drive circuitry 20 generates signals of triangular waveform which are supplied to X-Y coils (c.f. 123 in Fig. 2) for propagating magnetic bubbles in a magnetic bubble memory chip of the device 10. The function drive circuit 30 controls the propagation of the magnetic bubbles by feeding respective control signals to various gates of the magnetic bubble memory device such as bubble generator gates (not shown), replicator gates (c.f. 116 in Fig. 2) and swap gates (c.f. 115 in Fig. 2). Sense amplifier circuit 40 amplifies and converts output signals, of mV-level, from a detector (c.f. 117 in Fig. 2) of the magnetic bubble memory device to a TTL level, and outputs converted signals from the module to digital peripheral circuits (shown in Fig. 4).

The devices and circuits mentioned above may be of conventional type. Details of structure and operation of these elements, therefore, will not be described further for the sake of simplicity.

Arrows with reference numerals shown on the left hand side of Fig. 3 indicate various digital signals, at TTL level, which are input to the module: arrows 20-1 to 20-4 indicate timing signals for the coil drive circuit 20, arrows 30-1 to 30-5 indicate gate timing signals, arrow 30-6 indicates a chip selecting signal, arrow 40-1 indicates a DC reproducing timing signal, and arrow 40-2 indicates a strobe signal. Arrow 40-3 indicates an output signal at TTL level, which is output from the sense amplifier circuit 40 to the digital peripheral circuit (see Fig. 4). Power supply terminals to the coil drive circuit 20, function drive circuit 30 and sense amplifier circuit 40 are indicated respectively by arrows 50-1 to 50-5, which carry power supply voltages of +5V, +12V, -12V, -5V and 0V in the recited order. Arrows 60-1 and 60-2 indicate lead terminals to an erase coil (not shown; c.f. Fig. 2) of the magnetic bubble memory device 10.

The total system of a magnetic bubble memory apparatus is illustrated in the schematic block circuit diagram of Fig. 4. The system comprises N magnetic bubble memory modules, 1-1 to 1-N each as described above, and their digital peripheral circuits which latter comprise a gate controller 70, a sequencer 71, a timing generator 72, a decoder 73, a voltage detector 74 and an oscillator 75. When write-in or read-out digital signals are fed to the magnetic bubble memory apparatus from a host apparatus, a host computer for instance, these input digital signals are processed by the digital peripheral circuits to select one of the magnetic bubble memory modules 1-1 to 1-N and to carry out the write-in or read-out operation, resulting in feeding back of an output sense signal to the host apparatus. These circuits and their operations may be of conventional type and further description thereof will be omitted.

The concern of present invention lies in mechanical structure of a magnetic bubble memory module comprising a (one or more) magnetic bubble memory device and relevant analog peripheral circuits.

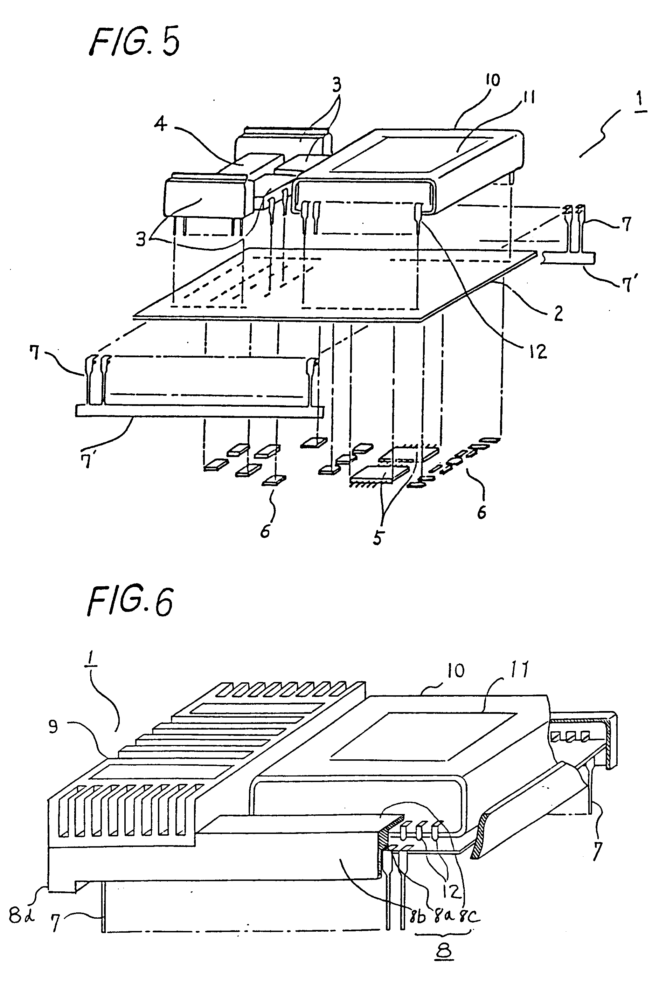

For assistance in explaining features which can be provided in an embodiment of the present invention, reference is made to the exploded perspective view of Fig. 5. In the module 1, on the front (upper) surface of a substrate, hereby a multi-layered or bilateral printed circuit board 2, there are mounted four IC's 3 for an X-Y coil driver, an IC 4 for function driver, and a magnetic bubble memory device 10. On the rear (lower) surface of the substrate 2 there are mounted two IC's 5, for a sense amplifier, and electrical chip elements 6 such as resistors and condensers. Outer or external lead terminals 7, for mounting the magnetic bubble memory module 1 on to another printed circuit board of other apparatus, are arranged in two lines and extend in a direction perpendicular to the surfaces of the substrate or printed circuit board 2. This enables the magnetic bubble memory module 1 to be mounted easily onto a printed circuit board of an electrical apparatus; as easily as a packaged IC. Terminals 7 are usually supplied to a production line in a comb-like ribbon form wherein each lead terminal is connected to each other in sequence by a connecting portion 7' which is cut away after fixing of the lead terminals 7 to the printed circuit board 2.

After mounting of the parts described above on the printed circuit board 2, the rear (lower) surface of the board 2 is covered with a layer of thermosetting resin which covers all the elements mounted on that surface to protect the elements from heating during a soldering operation involved when mounting the module 1 on another printed circuit board. Parts generating heat, namely IC's 3 and 4 for the coil driver and the function driver are selected to be mounted on the front (upper) surface of the substrate or printed circuit board 2, so that heat in relatively large quantity can be dissipated effectively therefrom. The magnetic bubble memory device 10 is also mounted on the front (upper) surface of the printed circuit board 2, in order to that a bad loop ID (identification) label 11 on the surface of the magnetic bubble memory device 10 can be read easily (the label indicates defects contained in the magnetic bubble memory device 10 for assistance with regard to write-in and read-out operations in the device). Thus, the magnetic bubble memory module 1 described above can be handled as easily as are IC's during work involved in their mounting onto a printed circuit board.

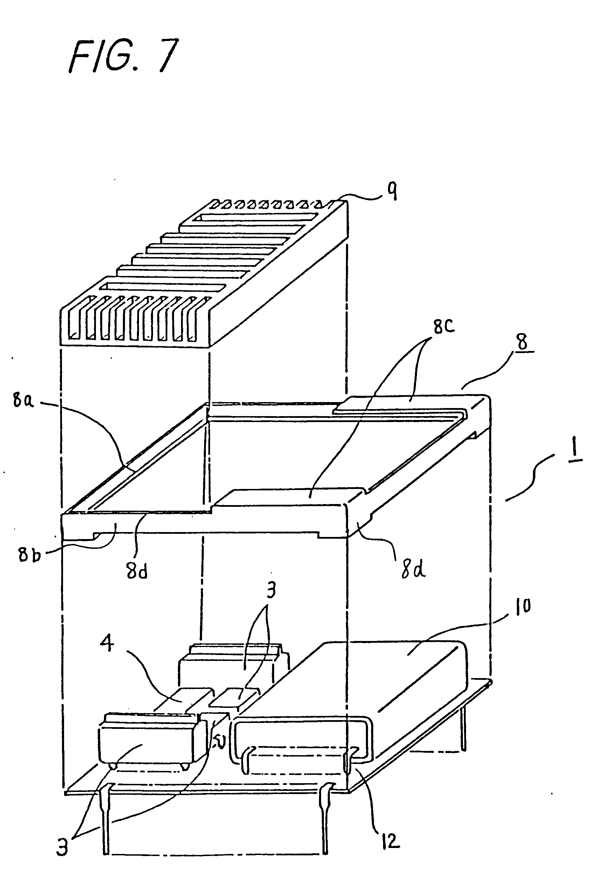

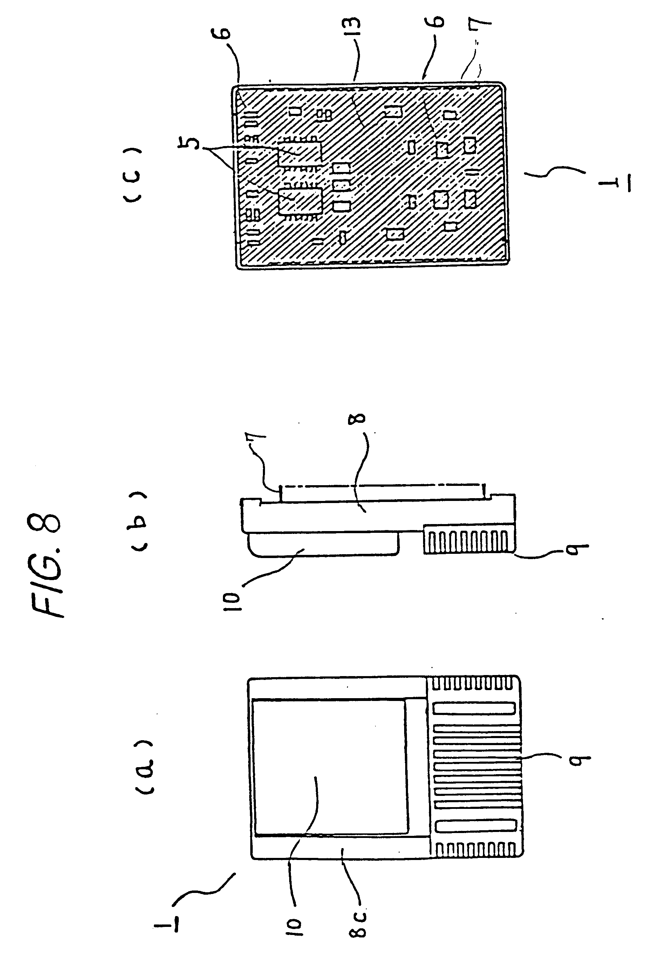

An embodiment of the present invention is illustrated in the perspective view of Fig. 6 and in the partly exploded perspective view of Fig. 7. A plan view, a side view and a rear view of the second embodiment are illustrated respectively in Fig. 8(a), (b) and (c).

Main parts are shown separately (exploded apart) in Fig. 7 to better display the mounting structure.

As compared with Fig. 5, the embodiment additionally provides means for protecting lead terminals 12 (see also Fig. 5) of the magnetic bubble memory device 10, which terminals extend from the package of the device 10, from electrostatic discharge damage as caused by the touch of a human body.

As well known, the human body stores static electrical charges, and therefore, the human body must not touch the magnetic bubble memory device 10 directly or indirectly through the lead terminals 12, otherwise information stored therein as magnetic bubbles may be damaged.

In particular, in a boot loop of magnetic bubble memory device 10, information regarding defects contained in the bubble memory chip, such as damaged conductor patterns of minor loops, is stored (this relates also to the information displayed on a label 11). Defects of the chip must be skipped when information is written in or read out from the minor loops. Accordingly, if this defect information in a boot loop is damaged, the entire magnetic bubble memory module becomes unavailable or unusable. In order to prevent the magnetic bubble memory device from being touched by the human body, for example by fingers during work for mounting the module on a printed circuit board; a protector of insulator material such as plastic is additionally provided in the embodiment, for protecting the lead terminals 12.

In this case an insulative protector 8 as seen in Figs. 6, 7 and 8 is of plastic material such as polybutylene terephtalate (PBT), and has the shape of a rectangular frame as seen most clearly in Fig. 7. The protector 8 has surfaces 8a formed by step-like projections on internal wall faces of a frame-like portion 8b of the protector, inside of which the printed circuit board 2 is accommodated held by abutment against the surfaces 8a and surrounded tightly by the frame-like portion 8b.

After insertion of the printed circuit board 2 into the frame-like portion 8b, the protector 8 and the printed circuit board 2 are inverted and liquid thermosetting resin is poured thereon, and solidified by a subsequent heat treatment to form a thick plastic layer 13 (see Fig. 8(c)) and the two parts (protector 8 and p.c.b. 2) are fixed to each other. The plastic layer 13 on the rear surface of the printed circuit board 2 covers the electrical elements mounted thereon as shown by the hatched portion in the rear view of the module 1 shown in Fig. 8(c). The thermosetting resin used is silicon resin. Thus, the printed circuit board is reinforced by the protector 8 and the plastic layer 13.

Flange-like top portions 8c of the protector 8 are designed to cover the lead terminals 12 of the magnetic bubble memory device 10 so that the lead terminals 12 cannot be touched by fingers of workers. With this structure, the lead terminals 12 are protected completely.

Furthermore, outer wall surfaces of the frame-like portion 8b enable assembly workers conveniently to carry the module 1 with fingers or tools on those surfaces.

In addition, lift-off projections 8d are formed on the bottom edge of the frame-like portion 8b, which are valuable when mounting the module 1 on a printed circuit board by dip soldering. These lift-off projections help to maintain a gap between the bottom of the module 1 and the printed circuit board which assists in removal of residual chemicals used for cleaning after dip-soldering.

The protector 8 serves to support the total weight of the magnetic bubble memory module 1 when mounted on a printed circuit board. The module 1 is rather heavy because of drive coils and bias magnets involved. Accordingly, the structure supporting the module 1 by the frame-like portion 8b and lift-off projections 8d of the protector 8 is effective to provide magnetic bubble memory apparatus in which such modules are used with a more vibration-resistive structure and to reduce mechanical loads otherwise applied to the outer lead terminals 7.

In the embodiment of Figs. 6, 7 and 8, a heatsink 9 is provided to increase dissipation of heat generated in ICs 3 and 4 as shown in Fig. 6, 7 and 8. The heatsink 9 is put on the ICs 3 and 4 and liquid thermosetting resin having a high heat conductivity is filled therebetween, being solidified by a heat treatment, forming a heat conductive layer to take the heat to the heatsink 9 for dissipation. The heatsink 9 is positioned with the aid of the protector 8. The heatsink 9 is of aluminium which is coated black, having dissipation fins formed thereon as shown in Fig. 6 to Fig. 8. The heatsink 9 can reduce the temperature rise of the ICs 3 and 4 to approximately 40^{o}C. In addition, the heatsink 9 serves to increase the mechanical strength or rigidity of the printed circuit board 2, namely, the magnetic bubble memory module 1.

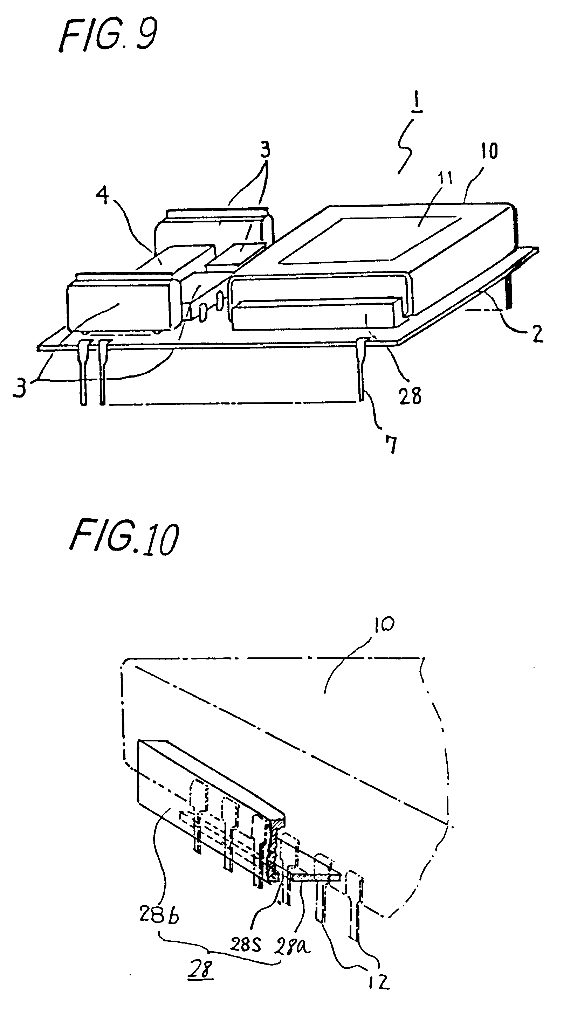

A second embodiment, which may be seen as representing a simplified modification of the first embodiment, is shown in the perspective view of Fig. 9. Small simple moulded plastic protectors 28 are positioned to cover the lead terminals 12 of the magnetic bubble memory device 10. Fig. 10 is a perspective view, partly cut away, showing detailed structure of a protector 28, illustrating a method used for mounting the protector 28 with respect to the substrate 2 of the magnetic bubble memory module 1. The protector 28 has a L-type cross-section, comprising base portion 28a, protection wall 28b and top flange 28c. In the base portion 28a, a long slit 28s is formed in the longitudinal direction of the protector, having a length and width sufficient to allow a line of lead terminals 12 of the magnetic bubble memory device 10 to pass therethrough. Thus the protectors 28 can be fixed to the printed circuit board 2 of the module 1, by passing the lead terminals 12 through their slits 28s beforehand, inserting the lead terminals 12 into through-holes (not shown) of the printed circuit board 2, and fixing the terminals 12 to the printed circuit board 2 by a conventional dip-soldering method. As a result, the lead terminals 12 of the magnetic bubble memory device 10 are prevented from being touched by means of the protectors 28. Of course, it wild be clear that the shape, and structure or the mounting method of the protector for the lead terminals of the magnetic bubble memory device can have various modifications and are not restricted to the second embodiment described above.

An embodiment of the present invention provides a magnetic bubble memory module containing a magnetic bubble memory device and its analog peripheral circuits mounted on a substrate, having outer input/output lead terminals, allowing the module to be mounted on a conventional printed circuit board instantaneously with other electronic elements. Lead terminals of the magnetic bubble memory device are protected by a protection means of insulator such as plastic material so that the magnetic bubble memory device is protected from electrostatic discharge damage caused by the touch of a charged body such as human fingers, resulting in high reliability and high production yield of the magnetic bubble memory apparatus.

The present invention provides a magnetic bubble memory module comprising:
a magnetic bubble memory device having a plurality of lead terminals extended from said device,
a plurality of analog peripheral circuits for driving and controlling said magnetic bubble memory device;
a plurality of outer lead terminals for receiving input signals to said analog peripheral circuits or sending output signals from said analog peripheral circuits;
a substrate for mounting said magnetic bubble memory device, analog peripheral circuits and outer lead terminals,
said protection means protecting said lead terminals of said magnetic bubble memory device from electrostatic discharge damage caused by the touch of any charged body,
said outer lead terminals being extended in the perpendicular direction to said substrate so that said magnetic bubble memory module being mountable to a printed circuit board.

## Claims

1. A magnetic bubble memory component (1), incorporating a magnetic bubble memory device (10) and analog peripheral circuitry (3, 4, 5, 6) for driving and controlling the device (10),
wherein
the device (10) and electrical elements forming the analog peripheral circuitry (3, 4, 5, 6) are mounted on a substrate (2) of the component (1),
the device (10) is mounted on the substrate (2) by means of lead terminals (12) of the device (10), and
the component (1) incorporates protection elements (8; 28) for protecting the device lead terminals (12) from contact by external bodies, thereby to avoid electrostatic discharge damage such as might be caused by contact with a charged body,
and wherein
the substrate (2) carries also lead terminals (7) of the component (1), for receiving electrical input signals for the peripheral circuitry (3, 4, 5, 6) and for delivering electrical output signals therefrom, which extend perpendicularly with respect to a main surface of the substrate (2) and are arranged along two lines, on opposite side edges of the substrate (2), whereby the component (1) is mountable on a printed circuit board by means of its lead terminals (7) by dip soldering, in the fashion of a dip-packaged IC.

2. A component as claimed in claim 1, wherein the protection elements (8; 28) are of insulative material.

3. A component as claimed in claim 1 or 2, wherein the protection elements (8; 28) are of plastics material.

4. A component as claimed in claim 1, 2 or 3, wherein the protection elements (8) comprise a frame-like member into which the substrate (2) is inserted, an inner wall surface of the frame-like member having a step-like portion which supports the substrate (2) and an abutment surface (8a) against which the substrate (2) abuts.

5. A component as claimed in claim 4, wherein the protection elements (8) further comprise flange-like portions (8c) on the frame-like member, which portions extend to cover over the lead terminals (12) of the magnetic bubble memory device (10).

6. A component as claimed in claim 4 or 5, wherein the substrate (2) is fixed rigidly to the frame-like member (8).

7. A component as claimed in claim 1, 2 or 3, wherein said protection elements (28) comprise a protection portion for protecting individually one group of lead terminals (12) of the said magnetic bubble memory device (10) which are arranged in a plane.

8. A component as claimed in claim 7, wherein the protection portion is an elongate member (28) having an L-shaped cross section with a longitudinal slit (28s) formed in the horizontal part of the L-shape, and a longitudinal top flange (28c) extending from the top of the vertical part (28b) of the L-shape in the same direction as the horizontal part, the lead terminals (12) of the group passing through the slit (28s) with the vertical part (28b) of the L-shape and the top flange (28c) enclosing the lead terminals (12) of the group.

9. A component as claimed in any preceding claim, wherein the substrate (2) has wiring areas on both main surfaces thereof, a front surface (upper surface) and a rear surface (lower surface).

10. A component as claimed in claim 9, wherein the substrate (2) is a printed circuit board.

11. A component as claimed in claim 9 or 10, wherein electrical elements of a coil driver for the magnetic bubble memory device and a function driver for the magnetic bubble memory device are mounted on the front surface of the substrate (2) and an electrical element of a sense amplifier is mounted on the rear surface of the substrate (2).

12. A component as claimed in claim 11, wherein a heatsink is attached to the electrical elements of the coil driver and the function driver by heat conductive adhesion material.

## Patentansprüche

1. Ein Magnetblasenspeicherbauelement (1), das eine Magnetblasenspeicheranordnung (10) und analoge periphere Schaltungen (3, 4, 5, 6) zum Treiben und Steuern der Anordnung (10) enthält,
bei dem
die Anordnung (10) und elektrische Elemente, die die analogen peripheren Schaltungen (3, 4, 5, 6) bilden, auf einem Substrat (2) des Bauelementes (1) montiert sind,
die Anordnung (10) auf dem Substrat (2) mittels Leitungsanschlüssen (12) der Anordnung (10) montiert ist, und
das Bauelement (1) Schutzelemente (8; 28) zum Schützen der Anordnungsleitungsanschlüsse (12) vor Kontakt mit externen Körpern enthält, um dadurch elektrostatischen Entladungsschaden zu verhindern, wie er durch Kontakt mit einem geladenen Körper verursacht werden könnte,
und bei dem
das Substrat (2) auch Leitungsanschlüsse (7) des Bauelementes (1) trägt, zum Empfangen von elektrischen Eingangssignalen für die peripheren Schaltungen (3, 4, 5, 6) und zum Liefern von elektrischen Ausgangssignalen von da aus, die sich in bezug auf eine Hauptoberfläche des Substrates (2) senkrecht erstrecken und längs zweier Reihen, auf gegenüberliegenden Seitenrändern des Substrates (2) angeordnet sind, wodurch das Bauelement (1) auf einer gedruckten Leiterplatte mittels seiner Leitungsanschlüsse (7) durch Tauchlöten, in der Art eines Tauchpackungs-IC's, montierbar ist.

2. Ein Bauelement nach Anspruch 1, bei dem die Schutzelemente (8; 28) aus Isoliermaterial bestehen.

3. Ein Bauelement nach Anspruch 1 oder 2, bei dem die Schutzelemente (8; 28) aus Plastmaterial bestehen.

4. Ein Bauelement nach Anspruch 1, 2 oder 3, bei dem die Schutzelemente (8) ein rahmenartiges Glied umfassen, in das das Substrat (2) eingesetzt ist, wobei eine innere Wandoberfläche des rahmenartigen Gliedes einen stufenartigen Teil hat, der das Substrat (2) stützt, und eine Angrenzungsoberfläche (8a), an die das Substrat (2) angrenzt.

5. Ein Bauelement nach Anspruch 4, bei dem die Schutzelemente (8) ferner flanschartige Teile (8c) auf dem rahmenartigen Glied umfassen, welche Teile sich erstrecken, um die Leitungsanschlüsse (12) der Magnetblasenspeicheranordnung (10) zu überdecken.

6. Ein Bauelement nach Anspruch 4 oder 5, bei dem das Substrat (2) auf dem rahmenartigen Glied (8) starr befestigt ist.

7. Ein Bauelement nach Anspruch 1, 2 oder 3, bei dem die genannten Schutzelemente (28) einen Schutzteil zum individuellen Schützen einer Gruppe von Leitungsanschlüssen (12) der genannten Magnetblasenspeicheranordnung (10) umfassen, die in einer Ebene angeordnet sind.

8. Ein Bauelement nach Anspruch 7, bei dem der Schutzteil ein langgestrecktes Glied (28) mit einem L-förmigen Querschnitt ist, mit einem länglichen Schlitz (28s), der in dem horizontalen Teil der L-Form gebildet ist, und einem länglichen oberen Flansch (28c), der sich vom Oberteil des vertikalen Teils (28b) der L-Form in dieselbe Richtung wie der horizontale Teil erstreckt, bei dem die Leitungsanschlüsse (12) der Gruppe den Schlitz (28s) passieren, wobei der vertikale Teil (28b) der L-Form und der obere Flansch (28c) die Leitungsanschlüsse (12) der Gruppe umschließen.

9. Ein Bauelement nach irgendeinem vorhergehenden Anspruch, bei dem das Substrat (2) Verdrahtungsbereiche auf seinen beiden Hauptoberflächen, eine vordere Oberfläche (obere Oberfläche) und eine hintere Oberfläche (untere Oberfläche) hat.

10. Ein Bauelement nach Anspruch 9, bei dem das Substrat (2) eine gedruckte Leiterplatte ist.

11. Ein Bauelement nach Anspruch 9 oder 10, bei dem elektrische Elemente eines Spulentreibers für die Magnetblasenspeicheranordnung und eines Funktionstreibers für die Magnetblasenspeicheranordnung auf der vorderen Oberfläche des Substrates (2) montiert sind, und ein elektrisches Element eines Leseverstärkers auf der hinteren Oberfläche des Substrates (2) montiert ist.

12. Ein Bauelement nach Anspruch 11, bei dem ein Kühlkörper mit den elektrischen Elementen des Spulentreibers und des Funktionstreibers durch wärmeleitendes Klebematerial verbunden ist.

## Revendications

1. Composant de mémoire à bulles magnétiques (1), incorporant un dispositif de mémoire à bulles magnétiques (10) et un circuit périphérique analogique (3, 4, 5, 6) pour piloter et commander le dispositif (10),
dans lequel
le dispositif (10) et des éléments électriques formant le circuit périphérique analogique (3, 4, 5, 6) sont montés sur un substrat (2) du composant (1),
le dispositif (10) est monté sur le substrat (2) au moyen de bornes de connexion (12) du dispositif (10) ; et
le composant (1) incorpore des éléments de protection (8 ; 28) pour protéger les bornes de connexion de dispositif (12) de tout contact par des corps externes afin d'ainsi éviter un quelconque dommage de décharge électrostatique tel que celui qui pourrait être provoqué par un contact avec un corps chargé,
et dans lequel
le substrat (2) supporte également des bornes de connexion (7) du composant (1), pour recevoir des signaux électriques d'entrée pour le circuit périphérique (3, 4, 5, 6) et pour délivrer depuis celles-ci des signaux électriques de sortie, lesquelles bornes de connexion s'étendent perpendiculairement à une surface principale du substrat (2) et sont agencées selon deux lignes, sur des bords latéraux opposés du substrat (2) d'où il résulte que le composant (1) peut être monté sur une plaquette de circuit imprimé au moyen de ses bornes de connexion (7) par soudage par immersion, à la façon d'un circuit intégré (IC) encapsulé par immersion.

2. Composant selon la revendication 1, dans lequel les éléments de protection (8 ; 28) sont en un matériau isolant.

3. Composant selon la revendication 1 ou 2, dans lequel les éléments de protection (8 ; 28) sont en une matière plastique.

4. Composant selon la revendication 1, 2 ou 3, dans lequel les éléments de protection (8) comprennent un élément formant cadre à l'intérieur duquel le substrat (2) est inséré, une surface de paroi interne de l'élément formant cadre comportant une partie en forme de marche qui supporte le substrat (2) et une surface de butée (8a) contre laquelle le substrat (2) vient en butée.

5. Composant selon la revendication 4, dans lequel les éléments de protection (8) comprennent en outre des parties formant flanc (8c) situées sur l'élément formant cadre, lesquelles parties s'étendent de façon à recouvrir les bornes de connexion (12) du dispositif de mémoire à bulles magnétiques (10).

6. Composant selon la revendication 4 ou 5, dans lequel le substrat (2) est fixé fermement à l'élément formant cadre (8).

7. Composant selon la revendication 1, 2 ou 3, dans lequel lesdits éléments de protection (28) comprennent une partie de protection pour protéger individuellement un groupe de bornes de connexion (12) dudit dispositif de mémoire à bulles magnétiques (10), lesquelles bornes étant agencées dans un plan.

8. Composant selon la revendication 7, dans lequel la partie de protection est un élément allongé (28) présentant une section en coupe en forme de L, une fente longitudinale (28s) étant formée dans la partie horizontale de la forme en L et un flanc supérieur longitudinal (28c) s'étendant depuis le sommet de la partie verticale (28b) de la forme en L suivant la même direction que celle de la partie horizontale, les bornes de connexion (12) du groupe traversant la fente (28s), la partie verticale (28b) de la forme en L et le flanc supérieur (28c) renfermant les bornes de connexion (12) du groupe.

9. Composant selon l'une quelconque des revendications précédentes, dans lequel le substrat (2) comporte des zones de câblage sur ses deux surfaces principales, sur une surface avant (surface supérieure) et sur une surface arrière (surface inférieure).

10. Composant selon la revendication 9, dans lequel le substrat (2) est une plaquette de circuit imprimé.

11. Composant selon la revendication 9 ou 10, dans lequel des éléments électriques d'un dispositif d'excitation de bobine pour le dispositif de mémoire à bulles magnétiques et d'un dispositif d'excitation de fonction pour le dispositif de mémoire à bulles magnétiques sont montés sur la surface avant du substrat (2) et un élément électrique d'un amplificateur de détection est monté sur la surface arrière du substrat (2).

12. Composant selon la revendication 11, dans lequel un dissipateur thermique est fixé aux éléments électriques du dispositif d'excitation de bobine et du dispositif d'excitation de fonction au moyen d'un matériau d'adhérence conducteur thermique.
